# EUROPEAN PATENT APPLICATION

(11) **EP 4 181 214 A1**
(43) Date of publication of application: **17.05.2023**
(21) Application number: 21837601.0
(22) Date of filing: 05.07.2021
(51) Int. Cl.: H01L 29/786, H01L 21/316, H01L 21/318, H01L 21/336, H01L 21/363

(54) **THIN FILM TRANSISTOR, THIN FILM TRANSISTOR ARRAY, AND THIN FILM TRANSISTOR PRODUCTION METHOD**

(30) Priority: 07.07.2020 JP 2020116804
(71) Applicant: TOPPAN INC., Tokyo 101-0024 (JP)
(72) Inventor: IKEDA, Noriaki, Tokyo 101-0024 (JP)
(74) Representative: Plasseraud IP
(86) International application number: PCT/JP2021/025258
(87) International publication number: WO 2022/009823

(57) **Abstract**

The present invention aims to provide a thin-film transistor having good device characteristics and high flexibility, a thin-film transistor array, and a method of producing a thin-film transistor. Accordingly, the thin-film transistor of the present invention includes an insulating substrate, a gate electrode, a first gate insulating layer, a second gate insulating layer, a semiconductor layer, an insulating protective layer, a source electrode, and a drain electrode. In the transistor, the first gate insulating layer is made of an insulating material containing an organic material; the second gate insulating layer is made of an inorganic insulating material; the second gate insulating layer has a thickness that is smaller than that of the first gate insulating layer; and the second gate insulating layer is formed only in an area overlapping the semiconductor layer or the protective layer.

## Description

### [Technical Field]

The present invention relates to thin-film transistors, thin-film transistor arrays, and methods of producing thin-film transistor arrays.

### [Background Art]

Thin-film transistors arrayed in a plane as a thin-film transistor array are widely used in active matrix display devices, such as liquid crystal displays (LCDs), organic electroluminescent (EL) displays, and electronic paper displays. Planar sensors or other sensors using thin-film transistor arrays are also being studied as applications of thin-film transistors.

In recent years, formation of thin-film transistors on a flexible substrate, to form flexible thin-film transistors for use in producing flexible display devices or sensors has been studied.

As semiconductor materials used for thin-film transistors, there are known inorganic semiconductor materials such as amorphous silicon, polycrystalline silicon, and oxide semiconductors, organic semiconductor materials, and other materials.

In particular, organic semiconductor materials, which are characterized by flexibility and low-temperature formability compared to inorganic semiconductor materials, are used as semiconductor materials for flexible thin-film transistors that use plastic substrates (NPTL 1).

### [Citation List]

### [Patent Literatures]

PTL 1: JP 5489429 B

### [Non Patent Literature]

NPTL 1 : "Organic thin-film transistor-driven polymer-dispersed liquid crystal displays on flexible polymeric substrates" by C. D. Sheraw, L. Zhou, J. R. Huang, D. J. Gundlach, and T.N. Jackson, Applied Physics Letters, 80, 1088 (2002)
NPTL 2 : "Improving positive and negative bias illumination stress stability in parylene passivated IGZO transistors" by Asal Kiazadeh, Henrique L. Gomes, Pedro Barquinha, Jorge Martins, Ana Rovisco, Joana V. Pinto, Rodrigo Martins, and Elvira Fortunato, Applied Physics Letters, 109, 051606 (2016).

### [Summary of the Invention]

### [Solution to Problem]

However, although organic thin-film transistors using organic semiconductor materials are characterized by low-temperature formability and high flexibility, their characteristics are unsatisfactory due to low mobility in the organic semiconductor materials.

Thin-film transistors using silicon-based and oxide-based semiconductors can achieve good characteristics but it is difficult to achieve high flexibility due to the insulating layers made of inorganic materials being combined with semiconductors.

To solve these issues, there is known a technique of using a highly flexible organic insulating material as a gate insulating film and sandwiching an inorganic insulating material between a semiconductor layer made of a metal oxide material and the gate insulating layer to form an oxide thin-film transistor having flexibility (e.g., PTL 1).

It is known that, in thin-film transistors using oxide semiconductors, the effects of gases adsorbed on the surfaces of the semiconductor layers and other factors have extremely great influences on their characteristics or stability (e.g., PTL 2). Protecting the semiconductor layers from external influences is a very important factor to achieve a thin-film transistor having good characteristics and reliability.

The present invention aims to provide a thin-film transistor having good device characteristics and high flexibility, a thin-film transistor array, and a method of producing a thin-film transistor.

### [Solution to Problem]

In order to solve the above issues, one of the typical thin-film transistors of the present invention includes an insulating substrate, a gate electrode, a first gate insulating layer, a second gate insulating layer, a semiconductor layer, an insulating protective layer, a source electrode, and a drain electrode. In the transistor, the first gate insulating layer is made of an insulating material containing an organic material; the second gate insulating layer is made of an inorganic insulating material; the second gate insulating layer has a thickness that is smaller than that of the first gate insulating layer; and the second gate insulating layer is formed only in an area overlapping the semiconductor layer or the protective layer.

### [Advantageous Effects of the Invention]

According to the present invention, there can be provided a thin-film transistor having good device characteristics and high flexibility, a thin-film transistor array, and a method of producing a thin-film transistor.

Issues, configurations, and advantageous effects other than those described above will be clarified in the following description for embodiments.

### [Brief Description of the Drawings]

Fig. 1 is a set of schematic cross-sectional view and schematic plan view each illustrating a thin-film transistor according a first embodiment of the present invention.
Fig. 2 is a set of schematic cross-sectional views illustrating a process of producing the thin-film transistor according to the first embodiment of the present invention.
Fig. 3 is a schematic plan view illustrating a thin-film transistor array according to the first embodiment of the present invention.
Fig. 4 is a schematic cross-sectional view illustrating a region where gate electrode wiring intersects source electrode wiring in the thin-film transistor array according to the first embodiment of the present invention.
Fig. 5 is a schematic cross-sectional view illustrating a thin-film transistor according to a second embodiment of the present invention.
Fig. 6 is a set of schematic cross-sectional views illustrating a process of producing the thin-film transistor according to the second embodiment of the present invention.
Fig. 7 is a set of schematic cross-sectional views each illustrating a thin-film transistor according to a third embodiment of the present invention.
Fig. 8 is a set of schematic cross-sectional views each illustrating a thin-film transistor according to a fourth embodiment of the present invention.
Fig. 9 is a schematic cross-sectional view illustrating a thin-film transistor according to Comparative Example 1.
Fig. 10 is a schematic cross-sectional view illustrating a thin-film transistor according to Comparative Example 2.
Fig. 11 is a graph showing transmission characteristics of thin-film transistors according to the examples of the present invention.
Fig. 12 is a graph showing transmission characteristics of thin-film transistors according to comparative examples.
Fig. 13 is a graph showing transmission characteristics of thin-film transistors in a bent state according to the examples of the present invention and a comparative example.
Fig. 14 is a graph showing transmission characteristics of a thin-film transistor according to Example 4 of the present invention.
Fig. 15 is a graph showing transmission characteristics of a thin-film transistor according to Example 5 of the present invention.
Fig. 16 is a graph showing transmission characteristics of a thin-film transistor according to Example 6 of the present invention.

### [Description of the Embodiments]

Referring to the drawing, some embodiments of the present invention will be described. It should be noted that the present invention should not be construed as being limited to the following embodiments. In the drawings, components identical with each other are given the same reference signs.

### (First Embodiment)

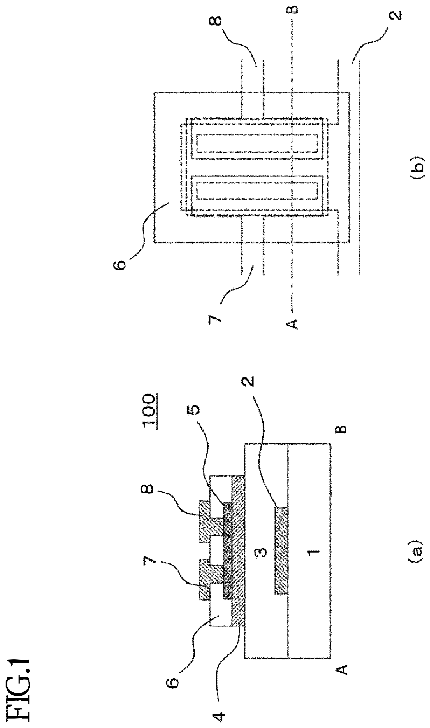

Fig. 1(a) is a schematic cross-sectional view illustrating a thin-film transistor 100 and Fig. 1(b) is a schematic plan view illustrating the thin-film transistor 100, according to a first embodiment of the present invention. Fig. 1(a) shows a cross section taken along the line AB of Fig. 1(b).

The thin-film transistor 100 includes at least an insulating substrate 1, a gate electrode 2, a first gate insulating layer 3, a second gate insulating layer 4, a semiconductor layer 5, an insulating protective layer 6, a source electrode 7, and a drain electrode 8.

As shown in Fig. 1, in the thin-film transistor 100, the gate electrode 2 is formed on the substrate 1, the first gate insulating layer 3 is formed on the gate electrode 2, the second gate insulating layer 4 is formed on the first gate insulating layer 3, the semiconductor layer 5 is formed on the second gate insulating layer 4, the protective layer 6 is formed on the semiconductor layer 5, and the source electrode 7 and the drain electrode 8 are formed on the protective layer 6 so as to be connected to the semiconductor layer 5. The second gate insulating layer 4 is formed only in an area overlapping the semiconductor layer 5 or the protective layer 6.

The first gate insulating layer 3 is formed of a material containing an organic material as a main component, while the second gate insulating layer 4 is formed of an inorganic material. Thus, by forming the second gate insulating layer 4 contacting the semiconductor layer 5 using an inorganic material, a favorable interface between the gate insulating layer and the semiconductor layer 5 can be maintained, thereby achieving good transistor characteristics. Also, the second gate insulating layer 4 can be patterned so as to be formed only in an area overlapping the semiconductor layer 5 or the protective layer 6 to improve flexibility.

Furthermore, the thin-film transistors 100 can be arrayed to form a thin-film transistor array for use as electronic devices such as image display devices or sensors. When used as an electronic device, each thin-film transistor can include an interlayer insulating film, pixel electrode, sensor electrode, counter electrode, and an opposing second substrate, not shown; however, the structure can be appropriately changed depending on the type of the electronic device to be produced.

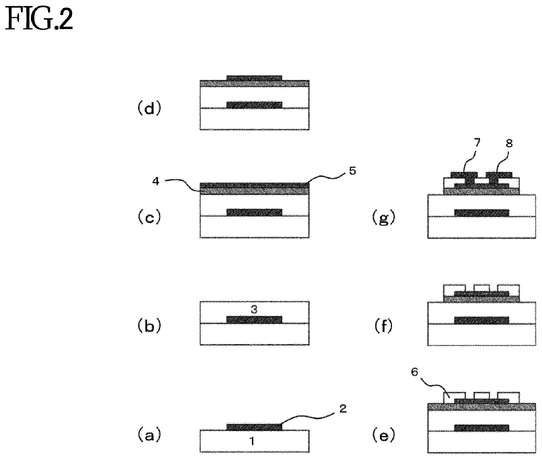

Referring to Fig. 2, each component of the thin-film transistor 100 will be described, along with a method of producing the thin-film transistor 100.

As shown in Fig. 2(a), a substrate 1 is prepared first. Materials that can be used for the substrate 1 include, but are not limited to, polycarbonates, polyethylene sulfide, polyethersulfones, polyethylene terephthalate, polyethylene naphthalate, cycloolefin polymers, ethylene-tetrafluoroethylene copolymer resins, glass fiber reinforced acryl resin films, polyimides, fluororesins, and thin glass plates. These materials may be used singly or laminating two or more as a composite substrate 1.

If the substrate 1 is an organic film, a gas barrier layer (not shown) may be formed in order to improve durability of the thin-film transistor 100. Materials for the gas barrier layer include, but are not limited to, aluminum oxide (Al₂O₃), silicon oxide (SiOₓ), silicon nitride (SiNₓ), silicon oxynitride (SiON), silicon carbide (SiC), and diamond-like carbon (DLC). These gas barrier layers can be used as a laminate of two or more layers. The gas barrier layer may be formed on only one surface or both surfaces of the substrate 1 which uses an organic film. The gas barrier layer can be formed using vacuum vapor deposition, ion plating, sputtering, laser ablation, plasma CVD (chemical vapor deposition), hot wire CVD, and sol-gel methods, but it is not limited thereto.

Next, as shown in Fig. 2(a), a gate electrode 2 is formed on the substrate 1. There is no need to clearly separate between the electrode portions and the wiring portions in the gate electrode 2, the source electrode 7, and the drain electrode 8 of the thin-film transistor. In the following, these portions, including the wiring portions, are referred to as electrodes as components of the thin-film transistor 100.

Materials that can be used for the gate electrode 2 are metal materials such as silver (Ag), aluminum (Al), copper (Cu), molybdenum (Mo), chromium (Cr), titanium (Ti), tungsten (W), manganese (Mn), niobium (Nb), and tantalum (Ta). Also, electrically conductive metal oxide materials such as indium oxide (InO), tin oxide (SnO), zinc oxide (ZnO), indium tin oxide (ITO), and indium zinc oxide (IZO) can be used. These materials may be used in a single layer or in laminated layers, or may be used as an alloy thereof. Aluminum alloys, which have high flexibility, good electrical conductivity, and good processability, are preferred to be used, but it is not particularly limited thereto.

The gate electrode 2 can be formed using vacuum deposition such as vacuum vapor deposition and sputtering, a sol-gel method using a precursor or the like of an electrically conductive material, wet deposition such as a method of using nanoparticles in the form of an ink for screen printing, relief printing, or inkjet printing, or other methods. However, the methods are not limited to these, but any commonly known method can be used. The gate electrode 2 can be patterned, for example, using photolithography in which the patterning area of the electrode is protected with a resist or the like and unnecessary portions of the electrode are etched away, or using printing or the like in which the electrode is directly patterned, but is not limited to these methods, but any commonly known patterning method can be used.

Next, as shown in Fig. 2(b), a first gate insulating layer 3 is formed on the gate electrode 2. The first gate insulating layer 3 is provided at least on the gate electrode 2 to electrically insulate the gate electrode 2 from electrodes such as the source and drain electrodes 7 and 8 and from the semiconductor layer 5, but may be provided throughout the surface of the substrate 1 except for the connecting portion of the gate electrode 2 to an external device.

Insulating materials including organic insulating materials are used for the first gate insulating layer 3. Examples of the organic insulating materials that can be used may include acrylic resins such as polymethyl methacrylates (PMMAs), and organic insulating resin materials such as polyvinyl alcohols (PVAs), polyvinyl phenols (PVPs), epoxy resins, polyimides, and parylenes. These materials may be used in a single layer or in a laminate of two or more layers, or may be used in the form of a thin film of an inorganic-organic resin hybrid material with a copolymer thereof or an inorganic material added thereto, or in the form of a thin film with the composition thereof graded in the growth direction. In particular, photoreactive resin materials that can be patterned using photolithography can be preferably used. Furthermore, the first gate insulating layer 3 may undergo surface treatment such as UV irradiation or self-assembled monolayer formation to control the surface energy of the first gate insulating layer 3 for improvement of adhesion with the second gate insulating layer to be formed on the first gate insulating layer.

The first gate insulating layer 3 can be formed using wet deposition such as spin coating and slit coating. The first insulating layer 3 can be patterned using any commonly known method. If a photoreactive resin material is used as the material of the first gate insulating layer 3, patterning can be performed through exposure and development using photolithography, and such a method can be preferably used.

The first gate insulating layer 3 is required to reliably cover at least the top of the gate electrode 2 except for the connecting portion thereof to an external device in order to electrically insulate the gate electrode 2 from other electrodes. The thickness of the layer is preferred to be 0.2 µm to 1.2 µm, and more preferred to be 0.5 µm to 1.0 µm.

### (Measurements of thickness)

The thickness can be measured using any commonly known method such as a method using a stylus step meter, a method using an atomic force microscope (AFM), and a method using a scanning electron microscope (SEM) to observe the cross section of a cut substrate. Depending on the size and shape of the sample and the thickness range, these methods can be appropriately selected for measurements.

The first gate insulating layer 3 is preferred to have a resistivity of 10¹¹ Qcm or more, and more preferably 10¹⁴ Qcm or more in order to suppress leakage current in the thin-film transistor 100. The first gate insulating layer 3 is preferred to have a relative dielectric constant of about 2.0 to 5.0.

### (Measurements of resistivity)

Resistivity can be measured by preparing a measurement capacitor device with electrodes formed on the top and bottom of the first gate insulating layer 3, separately from the thin-film transistor 100 of the present invention, and measuring the current when a voltage is applied to the top and bottom electrodes.

### (Measurements of relative dielectric constant)

Relative dielectric constant can be measured using a capacitor device as in the measurements of resistivity. Specifically, relative dielectric constant can be calculated by applying a voltage to the measurement capacitor device at a desired frequency using an LCR meter or the like, and measuring the capacitance.

Next, a second gate insulating layer 4 is formed on the first gate insulating layer 3. Examples of the material that can be used for the second gate insulating layer 4 may include inorganic insulating materials such as silicon oxide, aluminum oxide, tantalum oxide, hafnium oxide, yttrium oxide, zirconium oxide, and silicon nitride. These materials may be used in a single layer or in a laminate of two or more layers, or may be used as a mixture thereof. Also, these materials may be used with the composition graded in a growth direction.

The second gate insulating layer 4 can be formed using vacuum deposition such as sputtering, atomic layer deposition (ALD), pulsed laser deposition (PLD), and chemical vapor deposition (CVD), wet deposition such as a sol-gel method using an organic metal compound as a precursor, or other methods.

As mentioned above, the second gate insulating layer 4 is made of an inorganic insulating material. Therefore, if the layer is excessively thick, the second gate insulating layer 4 may crack and be damaged due to the strain when the thin-film transistor 100 of the present invention is bent. Accordingly, the thickness of the second gate insulating layer 4 is preferred to be designed with a small thickness. By reducing the thickness of the second gate insulating layer 4, the strain can be mitigated and flexibility of the thin-film transistor 100 can be enhanced. However, if the thickness of the second gate insulating film 4 is excessively small, formation of the layer as a film may become difficult and it may also become difficult to ensure stability of the production processes, although the thickness may depend on the method of forming the layer to some extent. Therefore, the thickness of the second gate insulating layer 4 is preferred to be about 2 nm to 100 nm, and more preferred to be 5 nm to 50 nm.

The gate insulating layer 4 is preferred to have a resistivity of 10¹⁰ Qcm or more, and more preferably 10¹³ Qcm or more to prevent leakage current. Also, the relative dielectric constant is preferred to be 3 to 25. It is known that, in gate insulating layers of thin-film transistors, capacitance increases with the increase of the relative dielectric constant, and the induced charge increases accordingly, and therefore, better device characteristics can be achieved for the same thickness. In the present embodiment, the second gate insulating layer 4 is designed to have a sufficiently small thickness compared to that of the first gate insulating layer 3, and thus the effect of the gate insulating layers as a whole on the capacitance is not so large. Accordingly, as long as the second gate dielectric layer 4 in the above thickness range has the above resistivity and relative dielectric constant, the thickness of this layer, even if it is thin, should not particularly impair the effect thereof.

Next, as shown in Fig. 2(c), a semiconductor layer 5 is formed on the second gate insulating layer 4. For the semiconductor layer 5, an oxide of a metal selected from indium, gallium, zinc and tin, amorphous silicon, microcrystalline silicon, or the like can be used. Examples of the metal oxide material that can be used may include indium oxide, zinc oxide, gallium oxide, tin oxide, indium zinc oxide, indium gallium oxide, and indium gallium zinc oxide. Materials obtained by mixing these metal oxides with other metal elements, such as aluminum, zirconium, hafnium, tungsten, or magnesium can also be used.

The semiconductor layer 5 may be an amorphous film, a microcrystalline film, or a polycrystalline film. If a microcrystalline or polycrystalline film is used, deposition conditions of the semiconductor layer 5 may be controlled to form it as a microcrystalline or polycrystalline film, or after depositing an amorphous film, the amorphous film may be subjected to heating to form it as a microcrystalline or polycrystalline film. Crystallinity of the semiconductor layer 5 can be measured using X-ray diffraction (XRD) or other methods, and crystallinity of the amorphous film, or the microcrystalline or polycrystalline film can be evaluated using any commonly known method.

The semiconductor layer 5 can be formed using vacuum deposition such as sputtering, atomic layer deposition (ALD), pulsed laser deposition (PLD), and chemical vapor deposition (CVD), wet deposition such as a sol-gel method using an organic metal compound as a precursor, or other methods.

Carrier concentration of the semiconductor layer 5 can be controlled to a desired value using various means to control the device characteristics of the thin-film transistor 100. For example, if the semiconductor layer 5 is a metal oxide, oxygen concentration during deposition can be controlled to control oxygen deficiency in the film, thereby controlling carrier concentration. Carrier concentration can be varied by changing the metal composition ratio of the metal oxide, and can be appropriately controlled depending on the metal element used. Alternatively, the semiconductor layer 5, after being formed, may be subjected to heating to control carrier concentration to an optimum level.

The region acting as a transistor channel region in the semiconductor layer 5 of the thin-film transistor 100 is an extremely thin region at the interface of the semiconductor layer 5 contacting the second gate insulating layer 4 in the thickness direction of the semiconductor layer 5. Therefore, a good interface is required to be maintained between the second gate insulating layer 4 and the semiconductor layer 5. Specifically, a surface roughness (Ra) at the interface between the second gate insulating layer and the semiconductor layer 5 is preferred to be 2 nm or less, and more preferred to be 1 nm or less.

As mentioned above, the region acting as a channel in the thickness direction of the semiconductor layer 5 is an extremely thin region, and the device can be operated as a transistor even if the thickness of the semiconductor layer 5 is extremely small. However, in order to form a semiconductor layer 5 with stable properties, the thickness of the semiconductor layer 5 is preferred to be 5 nm or more and 100 nm or less, and more preferred to be 15 nm or more and 40 nm or less.

As for the region where the semiconductor layer 5 is formed, if the semiconductor layer 5 is provided throughout the surface of the substrate, leakage current may be produced between adjacent thin-film transistors if a thin-film transistor array is formed using the thin-film transistors 100. Therefore, the semiconductor layer 5 is preferred to be patterned as shown in Fig. 2(d). It is preferred to pattern the semiconductor layer 5 to have a smallest possible formation area in order to pattern the second gate insulating layer 4 with a smallest possible formation area thereof in the patterning process of the second gate insulating layer 4 described later. However, the semiconductor layer 5 is required to be patterned so as to have at least the channel region of the thin-film transistor 100 and connecting portions to the source and drain electrodes 7 and 8. The semiconductor layer 5 can be patterned using any commonly known method, and thus a method such as photolithography can be preferably used.

Next, as shown in Fig. 2(e), a protective layer 6 is formed on the semiconductor layer 5. The protective layer 6 is formed covering at least the channel region of the semiconductor layer 5 in plan view to protect the back channel portion of the semiconductor layer 5. The back channel portion refers to a region that is the surface of the semiconductor layer 5 when it is formed, that is, the surface opposed to the interface where the channel is formed in the semiconductor layer 5. It is known that the electronic state of the semiconductor layer 5 is affected by the back channel portion being exposed to chemical substances or adsorbing gases from the atmosphere. Accordingly, it is very important to protect the back channel portion of the semiconductor layer 5 with the protective layer 6 and keep it in a favorable condition to achieve good device characteristics.

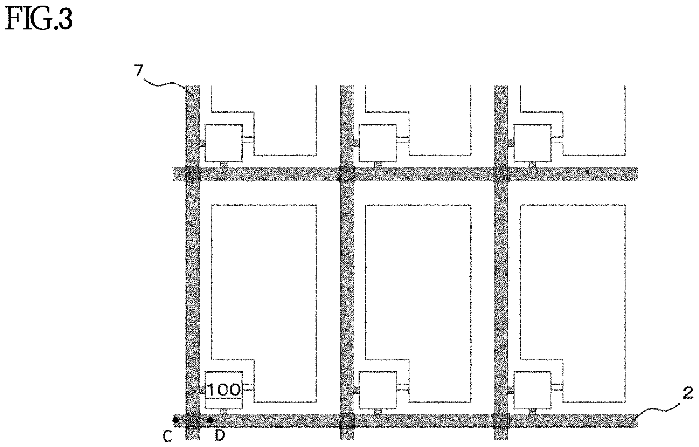

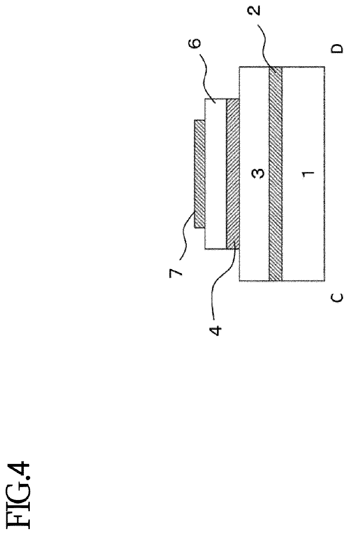

When the thin-film transistor 100 is used as a thin-film transistor array, the second gate insulating layer 4 and the protective layer 6 can be formed in the region where electrode wirings such as the gate electrode wiring and the source electrode wiring intersect each other. Fig. 3 is a schematic plan view illustrating a thin-film transistor array, and Fig. 4 is a schematic cross-sectional view illustrating a region where the gate electrode wiring and the source electrode wiring intersect each other in the thin-film transistor array. Fig. 4 shows a cross section taken along the line CD of Fig. 3. In the region where the gate electrode wiring 2 intersects the source electrode wiring 7, the second gate insulating layer 4 and the protective layer 6 are formed in addition to the first gate insulating layer 3. Thus, insulation properties of the region where these electrode wirings intersect each other can be improved.

For the protective layer 6, an insulating material is used. Examples of the insulating material that can be used may include inorganic insulating materials such as silicon oxide, aluminum oxide, tantalum oxide, hafnium oxide, yttrium oxide, zirconium oxide, and silicon nitride, acrylic resins such as polymethyl methacrylates (PMMAs), and organic insulating resin materials such as polyvinyl alcohols (PVAs), polyvinyl phenols (PVPs), epoxy resins, polyimides, and parylenes. These materials may be used in a single layer or in a laminate of two or more layers, or may be used in the form of a thin film of a mixture or copolymer thereof, or a thin film of an inorganic-organic resin hybrid material, or a thin film in which the composition is graded in the growth direction. If the protective layer 6 is used as a laminate of an oxide insulating material and an organic insulating material, the order of lamination is not particularly specified, but it is preferred to use a method in which an inorganic material is formed followed by forming an organic material, and the inorganic material is patterned using the organic material as a mask.

The protective layer 6 is preferred to have a resistivity of 10¹¹ Qcm or more, and more preferably 10¹⁴ Qcm or more in order to prevent leakage current from the semiconductor layer or the electrodes such as the source and drain electrodes 7 and 8.

The protective layer 6, if an organic material is used therefor, is preferred to have a thickness equal to or smaller than that of the first gate insulating layer 3. If an inorganic material is used, the protective layer 6 is preferred to have a thickness equivalent to that of the second gate insulating layer 4. The protective layer 6 is preferred to have a forward tapered pattern-end portion. The forward tapered pattern-end portion can contribute to preventing disconnection of the source and drain electrodes 7 and 8 formed on the protective layer 6.

The protective layer 6 can be formed appropriately depending on the material, using vacuum deposition such as sputtering, CVD, ALD and PLD, or wet deposition such as spin coating, slit coating and printing.

As shown in Fig. 2(f), following the formation of the protective layer 6, the second gate insulating layer 4 is patterned conforming to the area where the protective layer 6 or the semiconductor layer 5 is formed. The second gate insulating layer 4 may be patterned by forming a resist on the semiconductor layer 5 and the protective layer 6, followed by etching using the resist as a mask, or may be patterned by performing etching using the semiconductor layer 5 or the protective layer 6 as a mask. If etching is performed using the semiconductor layer 5 or the protective layer 6 as a mask, the process of forming a resist on the semiconductor layer 5 and the protective layer 6 can be omitted. The second gate insulating layer 4 can be etched using a method suitably selected for the material of the second gate insulating layer. For example, any commonly known method may be used, including dry etching such as reactive ion etching (RIE) or plasma etching (PE), or wet etching using an etchant.

Since the thin-film transistor 100 has high flexibility, a large strain may be caused therein when it is bent. Accordingly, the second gate insulating layer 4, if it is formed of an inorganic material, is patterned to have a smallest possible formation area, so that the strain of the second gate insulating layer 4 can be mitigated when it is bent, thereby preventing damage to the thin-film transistor 100 when the device is bent.

By patterning the second gate insulating layer 4 following the formation of the protective layer 6, the surface of the second gate insulating layer 4 can be prevented from being damaged or contaminated due to the patterning, or the back channel portion that is the surface of the semiconductor layer 5 can also be prevented from being damaged. Thus, a thin-film transistor 100 having good device characteristics can be achieved by maintaining a favorable condition at the interface between the second gate insulating layer 4 and the semiconductor layer 5 and at the back channel portion of the semiconductor layer 5.

Next, as shown in Fig. 2(g), a source electrode 7 and a drain electrode 8 are formed. The source and drain electrodes 7 and 8 can be formed using a material and a forming method similar to those of the gate electrode 2 described above

The source and drain electrodes 7 and 8 are formed for connection with the semiconductor layer 5 with an interval therebetween. The source and drain electrodes 7 and 8 may be separately formed using different materials; however, considering time and labor in the formation processes, they are preferred to be simultaneously formed using the same material. In order to reduce contact resistance of the source and drain electrodes 7 and 8 with the semiconductor layer 5, the semiconductor layer 5 can be plasma-treated at the connecting portions to the source and drain electrodes 7 and 8 before forming these electrodes.

### (Second Embodiment)

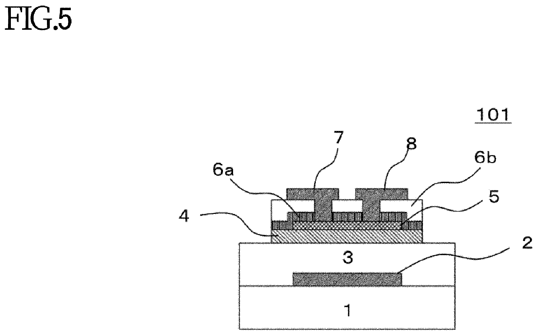

Fig. 5 is a schematic cross-sectional view illustrating a thin-film transistor 101 according to a second embodiment of the present invention.

As shown in Fig. 5, the thin-film transistor 101 is formed such that the protective layer 6 of the thin-film transistor 100 is formed of a first protective layer 6a and a second protective layer 6b. The remaining configuration is the same as in the thin-film transistor 100.

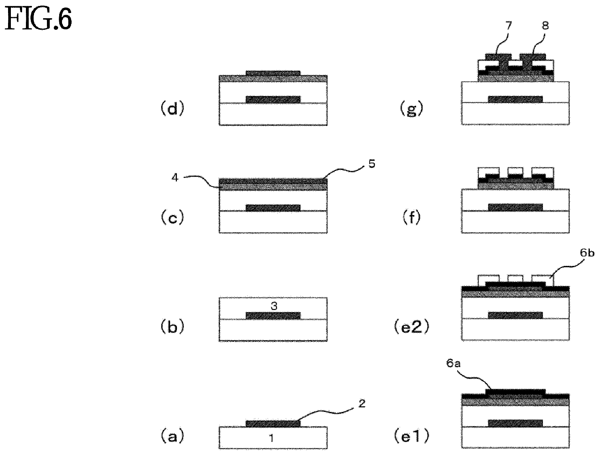

Referring to Fig. 6, a method of forming the thin-film transistor 101 will be described.

As shown in Fig. 6(e1), a first protective layer 6a is formed following the formation of the semiconductor layer 5. The first protective layer 6a can be formed using the same material as that of the second gate insulating layer 4. Also, the first protective layer 6a can be formed using the same method as that of the second gate insulating layer 4.

As shown in Fig. 6(e2), a second protective layer 6b is formed following the formation of the first protective layer 6a. The second protective layer 6b can be formed using the same material as that of the protective layer 6 of the thin-film transistor 100. Also, the second protective layer 6b can be formed using the same method as that of the protective layer 6 of the thin-film transistor 100.

As shown in Fig. 6(f), following the formation of the second protective layer 6b, the first protective layer 6a and the second gate insulating layer 4 are patterned conforming to the area where the second protective layer 6b or the semiconductor layer 5 is formed. If the first protective layer 6a and the second gate insulating layer 4 are formed using the same material, these layers can be patterned using the same method. The first protective layer 6a and the second gate insulating layer 4 may be patterned by performing etching using the semiconductor layer 5 or the second protective layer 6b as a mask.

The remaining processes are the same as those for the thin-film transistor 100. Thus, by forming the first protective layer 6a contacting the semiconductor layer 5 using an inorganic material, the interface between the protective layer and the semiconductor layer 5 can be maintained in a favorable condition, thereby achieving good transistor characteristics.

### (Third Embodiment)

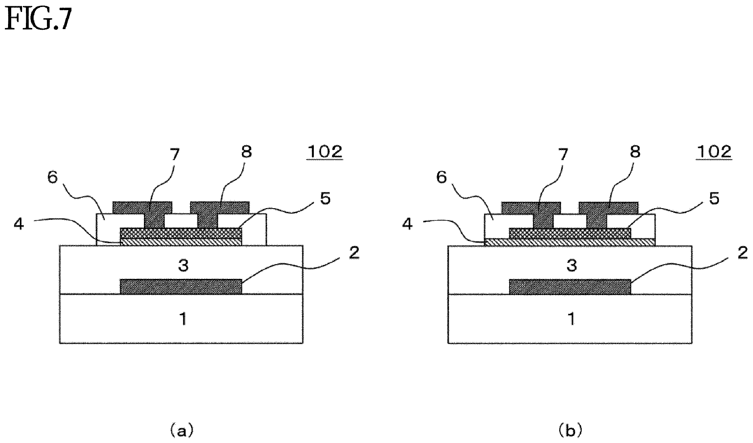

Fig. 7 is a set of schematic cross-sectional views each illustrating a thin-film transistor 102 according to a third embodiment of the present invention.

The thin-film transistor 102 includes at least an insulating substrate 1, a gate electrode 2, a first gate insulating layer 3, a second gate insulating layer 4, a semiconductor layer 5, an insulating protective layer 6, a source electrode 7, and a drain electrode 8.

As shown in Fig. 7, in the thin-film transistor 102, the gate electrode 2 is formed on the substrate 1, the first gate insulating layer 3 is formed on the gate electrode 2, the second gate insulating layer 4 is formed on the first gate insulating layer 3, the semiconductor layer 5 is formed on the second gate insulating layer 4, the protective layer 6 is formed on the semiconductor layer 5, and the source electrode 7 and the drain electrode 8 are formed on the protective layer 6 for connection to the semiconductor layer 5. The second gate insulating layer 4 is formed only in an area overlapping the semiconductor layer 5 or the protective layer 6.

Fig. 7(a) is a schematic cross-sectional view illustrating a thin-film transistor 102 in which the second gate insulating layer 4 is formed only in an area overlapping the semiconductor layer 5, and Fig. 7(b) is a schematic cross-sectional view illustrating a thin-film transistor 102 in which the second gate insulating layer 4 is formed only in an area overlapping the protective layer 6.

The first gate insulating layer 3 is formed of a material containing an organic material as a main component, while the second gate insulating layer 4 is formed of an inorganic material. Thus, by forming the second gate insulating layer 4 contacting the semiconductor layer 5 using an inorganic material, a favorable interface between the gate insulating layer and the semiconductor layer 5 can be maintained, thereby achieving good transistor characteristics. Also, the second gate insulating layer 4 can be patterned so as to be formed only in an area overlapping the semiconductor layer 5 or the protective layer 6 to improve flexibility.

Since the protective layer 6 is formed of a material containing an organic material having high flexibility as a main component, no cracking or separation occurs when the thin-film transistor is bent, so that flexibility of the thin-film transistor can be improved. Furthermore, if fluorine is contained in the protective layer 6, it can effectively block external gases or other substances affecting the surface of the semiconductor layer, so that good transistor characteristics can be achieved.

Furthermore, the thin-film transistors 102 can be arrayed to form a thin-film transistor array, which can be used as an electronic device such as an image display device or sensor. When used as an electronic device, each thin-film transistor can include an interlayer insulating film, pixel electrode, sensor electrode, counter electrode, and an opposing second substrate, not shown; however, the structure can be appropriately changed depending on the type of the electronic device to be produced.

Hereinafter, each component of the thin-film transistor 102 will be described, along with a method of producing the thin-film transistor 102.

First, a substrate 1 is prepared. Materials that can be used for the substrate 1 include, but are not limited to, polycarbonates, polyethylene sulfide, polyethersulfones, polyethylene terephthalate, polyethylene naphthalate, cycloolefin polymers, ethylene-tetrafluoroethylene copolymer resins, glass fiber reinforced acryl resin films, polyimides, fluororesins, and thin glass plates. These materials may be used singly or laminating two or more as a composite substrate 1.

If the substrate 1 is an organic film, a gas barrier layer (not shown) may be formed in order to improve durability of the thin-film transistor 102. Materials for the gas barrier layer include, but are not limited to, aluminum oxide (Al₂O₃), silicon oxide (SiOₓ), silicon nitride (SiNₓ), silicon oxynitride (SiON), silicon carbide (SiC), and diamond-like carbon (DLC). These gas barrier layers can be used as a laminate of two or more layers. The gas barrier layer may be formed on only one surface or both surfaces of the substrate 1 which uses an organic film. The gas barrier layer can be formed using vacuum vapor deposition, ion plating, sputtering, laser ablation, plasma CVD (chemical vapor deposition), hot wire CVD, and sol-gel methods, but it is not limited thereto.

Next, a gate electrode 2 is formed on the substrate 1. There is no need to clearly separate between the electrode portions and the wiring portions in the gate electrode 2, the source electrode 7, and the drain electrode 8 of the thin-film transistor. In the following, these portions, including the wiring portions, are referred to as electrodes as the components of the thin-film transistor 102.

Materials that can be used for the gate electrode 2 are metal materials such as silver (Ag), aluminum (Al), copper (Cu), molybdenum (Mo), chromium (Cr), titanium (Ti), tungsten (W), manganese (Mn), niobium (Nb), and tantalum (Ta). Also, electrically conductive metal oxide materials such as indium oxide (InO), tin oxide (SnO), zinc oxide (ZnO), indium tin oxide (ITO), and indium zinc oxide (IZO) can be used. These materials may be used in a single layer or in laminated layers, or may be used as an alloy thereof. Aluminum alloys, which have high flexibility, good electrical conductivity, and good processability, are preferred to be used, but it is not particularly limited thereto.

The gate electrode 2 can be formed using vacuum deposition such as vacuum vapor deposition and sputtering, a sol-gel method using a precursor or the like of an electrically conductive material, wet deposition such as a method of using nanoparticles in the form of an ink for screen printing, relief printing, or inkjet printing, or other methods. However, the methods are not limited to these, but any commonly known method can be used. The gate electrode 2 can be patterned, for example, using photolithography in which the patterning area of the electrode is protected with a resist or the like and unnecessary portions of the electrode are etched away, or using printing or the like in which the electrode is directly patterned, but is not limited to these methods, but any commonly known patterning method can be used.

Next, a first gate insulating layer 3 is formed on the gate electrode 2. The first gate insulating layer 3 is provided at least on the gate electrode 2 to electrically insulate the gate electrode 2 from electrodes such as the source and drain electrodes 7 and 8 and from the semiconductor layer 5, but may be provided throughout the surface of the substrate 1 except for the connecting portion of the gate electrode 2 to an external device.

Insulating materials including organic insulating materials are used for the first gate insulating layer 3. Examples of the organic insulating materials that can be used may include acrylic resins such as polymethyl methacrylates (PMMAs), and organic insulating resin materials such as polyvinyl alcohols (PVAs), polyvinyl phenols (PVPs), epoxy resins, polyimides, and parylenes. These materials may be used in a single layer or in a laminate of two or more layers, or may be used in the form of a thin film of an inorganic-organic resin hybrid material with a copolymer thereof or an inorganic material added thereto, or in the form of a thin film with the composition thereof graded in the growth direction. In particular, photoreactive resin materials that can be patterned using photolithography can be preferably used. Furthermore, the first gate insulating layer 3 may undergo surface treatment such as UV irradiation or self-assembled monolayer formation to control the surface energy of the first gate insulating layer 3 for improvement of adhesion with the second gate insulating layer to be formed on the first gate insulating layer.

The first gate insulating layer 3 can be formed using wet deposition such as spin coating and slit coating. The first insulating layer 3 can be patterned using any commonly known method. If a photoreactive resin material is used as the material of the first gate insulating layer 3, patterning can be performed through exposure and development using photolithography, and such a method can be preferably used.

The first gate insulating layer 3 is required to reliably cover at least the top of the gate electrode 2 except for the connecting portion thereof to an external device in order to electrically insulate the gate electrode 2 from other electrodes. The thickness of the layer is preferred to be 0.2 µm to 1.2 µm, and more preferred to be 0.4 µm to 1.0 µm.

### (Measurements of thickness)

The thickness can be measured using any commonly known method such as a method using a stylus step meter, a method using an atomic force microscope (AFM), and a method using a scanning electron microscope (SEM) to observe the cross section of a cut substrate. Depending on the size and shape of the sample and the thickness range, these methods can be appropriately selected for measurements.

The first gate insulating layer 3 is preferred to have a resistivity of 10¹¹ Qcm or more, and more preferably 10¹⁴ Qcm or more in order to suppress leakage current in the thin-film transistor 102. The first gate insulating layer 3 is preferred to have a relative dielectric constant of about 2.0 to 5.0.

### (Measurements of resistivity)

Resistivity can be measured by preparing a measurement capacitor device with electrodes formed on the top and bottom of the first gate insulating layer 3, separately from the thin-film transistor 102 of the present invention, and measuring the current when a voltage is applied to the top and bottom electrodes.

### (Measurements of relative dielectric constant)

Relative dielectric constant can be measured using a capacitor device as in the measurements of resistivity. Specifically, relative dielectric constant can be calculated by applying a voltage to the measurement capacitor device at a desired frequency using an LCR meter or the like, and measuring the capacitance.

Next, a second gate insulating layer 4 is formed on the first gate insulating layer 3. Examples of the material that can be used for the second gate insulating layer 4 may include inorganic insulating materials such as silicon oxide, aluminum oxide, tantalum oxide, hafnium oxide, yttrium oxide, zirconium oxide, and silicon nitride. These materials may be used in a single layer or in a laminate of two or more layers, or may be used as a mixture thereof. Also, these materials may be used with the composition graded in a growth direction.

The second gate insulating layer 4 can be formed using vacuum deposition such as sputtering, atomic layer deposition (ALD), pulsed laser deposition (PLD), and chemical vapor deposition (CVD), wet deposition such as a sol-gel method using an organic metal compound as a precursor, or other methods.

As mentioned above, the second gate insulating layer 4 is formed of an inorganic insulating material. Therefore, if the layer is excessively thick, the second gate insulating layer 4 may crack and be damaged due to the strain when the thin-film transistor 102 of the present invention is bent. Accordingly, the thickness of the second gate insulating layer 4 is preferred to be designed with a small thickness. By reducing the thickness of the second gate insulating layer 4, the strain can be mitigated and flexibility of the thin-film transistor 102 can be enhanced. However, if the thickness of the second gate insulating film 4 is excessively small, formation of the layer as a film may become difficult and it may also become difficult to ensure stability of the production processes, although the thickness may depend on the method of forming the layer to some extent. Therefore, the thickness of the second gate insulating layer 4 is preferred to be about 2 nm to 100 nm, and more preferred to be 5 nm to 50 nm.

The gate insulating layer 4 is preferred to have a resistivity of 10¹⁰ Qcm or more, and more preferably 10¹³ Qcm or more to prevent leakage current. Also, the relative dielectric constant is preferred to be 3 to 25. It is known that, in gate insulating layers of thin-film transistors, capacitance increases with the increase of the relative dielectric constant, and the induced charge increases accordingly, and therefore, better device characteristics can be achieved for the same thickness. In the present embodiment, the second gate insulating layer 4 is designed to have a sufficiently small thickness compared to that of the first gate insulating layer 3, and thus the effect of the gate insulating layers as a whole on the capacitance is not so large. Accordingly, as long as the second gate dielectric layer 4 in the above thickness range has the above resistivity and relative dielectric constant, the thickness of this layer, even if it is thin, should not particularly impair the effect thereof.

Next, a semiconductor layer 5 is formed on the second gate insulating layer 4. For the semiconductor layer 5, an oxide of a metal selected from indium, gallium, zinc and tin, amorphous silicon, microcrystalline silicon, or the like can be used. Examples of the metal oxide material that can be used may include indium oxide, zinc oxide, gallium oxide, tin oxide, indium zinc oxide, indium gallium oxide, and indium gallium zinc oxide. Materials obtained by mixing these metal oxides with other metal elements, such as aluminum, zirconium, hafnium, tungsten, or magnesium can also be used.

The semiconductor layer 5 may be an amorphous film, a microcrystalline film, or a polycrystalline film. If a microcrystalline or polycrystalline film is used, deposition conditions of the semiconductor layer 5 may be controlled to form it as a microcrystalline or polycrystalline film, or after depositing an amorphous film, the amorphous film may be subjected to heating to form it as a microcrystalline or polycrystalline film. Crystallinity of the semiconductor layer 5 can be measured using X-ray diffraction (XRD) or other methods, and crystallinity of the amorphous film, or the microcrystalline or polycrystalline film can be evaluated using any commonly known method.

The semiconductor layer 5 can be formed using vacuum deposition such as sputtering, atomic layer deposition (ALD), pulsed laser deposition (PLD), and chemical vapor deposition (CVD), wet deposition such as a sol-gel method using an organic metal compound as a precursor, or other methods.

Carrier concentration of the semiconductor layer 5 can be controlled to a desired value using various means to control the device characteristics of the thin-film transistor 102. For example, if the semiconductor layer 5 is a metal oxide, oxygen concentration during deposition can be controlled to control oxygen deficiency in the film, thereby controlling carrier concentration. Carrier concentration can be varied by changing the metal composition ratio of the metal oxide, and can be appropriately controlled depending on the metal element used. Alternatively, the semiconductor layer 5, after being formed, may be subjected to heating to control carrier concentration to an optimum level.

The region acting as a transistor channel region in the semiconductor layer 5 of the thin-film transistor 102 is an extremely thin region of the semiconductor layer 5 at the interface in contact with the second gate insulating layer 4 in the thickness direction of the semiconductor layer 5. Therefore, a good interface is required to be maintained between the second gate insulating layer 4 and the semiconductor layer 5. Specifically, a surface roughness (Ra) at the interface between the second gate insulating layer and the semiconductor layer 5 is preferred to be 2 nm or less, and more preferred to be 1 nm or less.

As mentioned above, the region acting as a channel in the thickness direction of the semiconductor layer 5 is an extremely thin region, and the device can be operated as a transistor even if the thickness of the semiconductor layer 5 is extremely small. However, in order to form a semiconductor layer 5 with stable properties, the thickness of the semiconductor layer 5 is preferred to be 5 nm or more and 100 nm or less, and more preferred to be 15 nm or more and 40 nm or less.

As for the region where the semiconductor layer 5 is formed, if the semiconductor layer 5 is provided throughout the surface of the substrate, leakage current may be produced between adjacent thin-film transistors if a thin-film transistor array is formed using the thin-film transistors 102. Therefore, the semiconductor layer 5 is preferred to be patterned. It is preferred to pattern the semiconductor layer 5 to have a smallest possible formation area in order to pattern the second gate insulating layer 4 with a smallest possible formation area thereof in the patterning process of the second gate insulating layer 4 described later. However, the semiconductor layer 5 is required to be patterned so as to have at least the channel region of the thin-film transistor 102 and connecting portions to the source and drain electrodes 7 and 8. The semiconductor layer 5 can be patterned using any commonly known method, and thus a method such as photolithography can be preferably used.

Following the formation of the semiconductor layer 5, the second gate insulating layer 4 is patterned conforming to the area where the semiconductor layer 5 is formed. The second gate insulating layer 4 may be patterned by performing etching using a resist as a mask as in the patterning of the semiconductor layer 5. The second gate insulating layer 4 can be etched using a method suitably selected for the material of the second gate insulating layer. For example, any commonly known method may be used, including dry etching such as reactive ion etching (RIE) or plasma etching (PE), or wet etching using an etchant.

Since the thin-film transistor 102 has high flexibility, a large strain may be caused therein when it is bent. Accordingly, the second gate insulating layer 4, if it is formed of an inorganic material, is patterned to have a smallest possible formation area, so that the strain of the second gate insulating layer 4 can be mitigated when it is bent, thereby preventing breaking of the thin-film transistor 102 when the device is bent.

By patterning the second gate insulating layer 4 following the formation of the semiconductor layer 5, the surface of the second gate insulating layer 4 can be prevented from being damaged or contaminated due to the patterning. Thus, a thin-film transistor 102 having good device characteristics can be achieved by maintaining a favorable condition at the interface between the second gate insulating layer 4 and the semiconductor layer 5.

Next, a protective layer 6 is formed on the semiconductor layer 5. The protective layer 6 is formed covering at least the channel region of the semiconductor layer 5 in plan view to protect the back channel portion of the semiconductor layer 5. The back channel portion refers to a region that is the surface of the semiconductor layer 5 when it is formed, that is, the surface opposed to the interface where the channel is formed in the semiconductor layer 5. It is known that the electronic state of the semiconductor layer 5 is affected by the back channel portion being exposed to chemical substances or adsorbing gases from the atmosphere. Accordingly, it is very important to protect the back channel portion of the semiconductor layer 5 with the protective layer 6 and keep it in a favorable condition to achieve good device characteristics.

When the thin-film transistor 102 is used as a thin-film transistor array, the second gate insulating layer 4 and the protective layer 6 can be formed in the region where electrode wirings such as the gate electrode wiring and the source electrode wiring intersect each other. Thus, insulation properties of the region where these electrode wirings intersect each other can be improved.

For the protective layer 6, an organic insulating material containing fluorine is used. Examples of such a material that can be used may include acrylic resins such as polymethyl methacrylates (PMMAs), and organic insulating resin materials such as polyvinyl alcohols (PVAs), polyvinyl phenols (PVPs), epoxy resins, polyimides, parylenes, and fluororesins. These materials may be used in a single layer or in a laminate of two or more layers, or may be used in the form of a thin film of a mixture or copolymer thereof, or a thin film of an inorganic-organic resin hybrid material, or a thin film in which the composition is graded in the growth direction. Using an insulating material formed of an organic material for the protective layer 6, high flexibility can be achieved without causing cracking in the protective layer when the thin-film transistor 102 is bent.

As the fluorine contained in the protective layer 6, fluororesins, organic resins having fluorine as part of their constituents, organic resins with fluorine materials added thereto, or other materials can be used. With the protective layer 6 containing fluorine, external chemical substances, or water or oxygen in the atmosphere, and the like are effectively prevented from being adsorbed to the semiconductor layer 5. In particular, increasing the fluorine concentration on the surface of the protective layer 6 can be highly effective at protecting the layer from external influences. If a fluorine-containing protective layer 6 is formed with a fluorine-based material added to an organic insulating material, a fluorine-based surfactant can be preferably used. Furthermore, as a surfactant, a nonionic surfactant is preferred to be used so as not to affect the insulation properties of the protective layer 6, charge accumulation, or the like.

The fluorine contained in the protective layer 6 can be evaluated using a time-of-flight secondary ion mass spectrometer (TOF-SIMS), or the like. In particular, in the analysis of fluorine content in the depth direction, a gas cluster ion beam (GCIB) is preferred to be used because the fluorine atoms may otherwise be easily desorbed by the ion beam used for depth analysis and this may make the analysis difficult. A simple way to estimate the fluorine concentration on the surface of the protective layer 6 is to measure the surface energy of the protective layer 6. Surface energy can be measured by dropping water or organic solvent on the surface and calculating the contact angle. The surface energy of the protective layer 6 is preferred to be 30 mJ/m² or less, and more preferred to be 25 mJ/m² or less.

The protective layer 6 is preferred to have a resistivity of 10¹¹ Qcm or more, and more preferably 10¹⁴ Qcm or more in order to prevent leakage current from the semiconductor layer or the electrodes such as the source and drain electrodes 7 and 8.

The thickness of the protective layer 6 is preferred to be about 0.3 µm or more and 3 µm or less. The protective layer 6 is preferred to have a forward tapered pattern-end portion. The forward tapered pattern-end portion can contribute to preventing disconnection of the source and drain electrodes 7 and 8 formed on the protective layer 6 or preventing the occurrence of defects in the pattern formed on the top.

The protective layer 6 can be formed appropriately depending on the material, using wet deposition such as spin coating, slit coating, or printing.

Next, a source electrode 7 and a drain electrode 8 are formed. The source and drain electrodes 7 and 8 can be formed using a material and a forming method similar to those of the gate electrode 2 described above

The source and drain electrodes 7 and 8 are formed for connection with the semiconductor layer 5 with an interval therebetween. The source and drain electrodes 7 and 8 may be separately formed using different materials; however, considering time and labor in the formation processes, they are preferred to be simultaneously formed using the same material. In order to reduce contact resistance of the source and drain electrodes 7 and 8 with the semiconductor layer 5, the semiconductor layer 5 can be plasma-treated at the connecting portions to the source and drain electrodes 7 and 8 before forming these electrodes.

### (Fourth Embodiment)

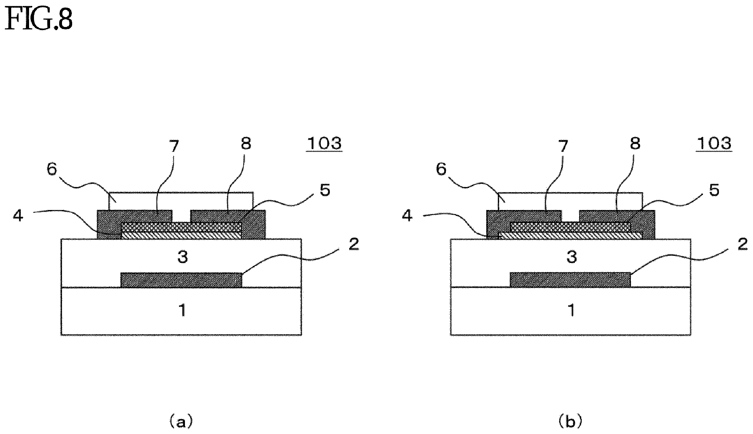

Fig. 8 is a set of schematic cross-sectional views each illustrating a thin-film transistor 103 according to a fourth embodiment of the present invention.

Fig. 8(a) is a schematic cross-sectional view illustrating a thin-film transistor 103 in which the second gate insulating layer 4 is formed only in an area overlapping the semiconductor layer 5, and Fig. 8(b) is a schematic cross-sectional view illustrating a thin-film transistor 103 in which the second gate insulating layer 4 is formed only in an area overlapping the protective layer 6.

As shown in Fig. 8, the thin-film transistor 103 is different from the thin-film transistor 102 in the order of forming the protective layer 6, and the source and drain electrodes 7 and 8.

In the thin-film transistor 103, the formation of the semiconductor layer 5 is followed by the formation of the source and drain electrodes 7 and 8. In this case, the source and drain electrodes 7 and 8 can be formed as in the formation of the source and drain electrodes 7 and 8 of the above thin-film transistor 102. However, if the source and drain electrodes 7 and 8 are formed using photolithography, an agent in which the semiconductor layer 5 is difficult to dissolve is required to be selected as an etchant or the like to be used so as not to damage the semiconductor layer 5 when these electrodes are etched. Also, dry etching can be preferably used for etching the source and drain electrodes 7 and 8.

Following the formation of the source and drain electrodes 7 and 8, a protective layer 6 is formed. The protective layer 6 can also be formed as in the formation of the thin-film transistor 102 of the third embodiment.

The protective layer 6 is preferred to be formed covering at least the semiconductor layer 5, but may be formed throughout the surface of the substrate except for the connecting portions of the electrodes, and the like.

The remaining processes are the same as those of the thin-film transistor 102. By forming the source and drain electrodes 7 and 8 preceding the formation of the protective layer 6, the thin-film transistor can be designed to have a shorter channel length and this leads to easily obtaining a higher current value.

If any of the thin-film transistors 100 to 103 is used for providing an electronic device such as an image display device or sensor device, additional components such as an insulating layer, electrode, display element, sensor element, and counter substrate are appropriately formed. Materials used for these components are not particularly limited, but the insulating layer may be formed of a material similar to the material of the first gate insulating layer 3 or the second gate insulating layer 4, and the electrode may be formed of a material similar to the material of the gate electrode 2. Also, the counter substrate may be formed of a material similar to that of the substrate 1, but it is not limited to this.

If the electronic device using any of the thin-film transistors 100 to 103 is an image display device, the display element that can be used may be liquid crystal, electrophoretic particles, organic electroluminescence, or the like. These commonly known display elements can be used for the image display device without being limited to either a reflective type or a transmissive type. Furthermore, depending on the display element used, the image display device may have a configuration in which one pixel is designed to include a plurality of organic thin-film transistors 100, 102 or 103.

If the electronic device using any of the thin-film transistors 100 to 103 is a sensor device, a material that reacts to temperature or pressure may be connected, as a sensor active layer, to any electrode of the thin-film transistor, or a functional film that is a self-assembled film or the like may be formed on any electrode of the thin-film transistor for use as an electrode that reacts to biomolecules, metal ions, and the like. Furthermore, depending on the application of the sensor used, the sensor can have a configuration in which a plurality of thin-film transistors 100, 102 or 103 are arranged.

### Examples

### (Example 1)

As Example 1, a thin-film transistor 100 shown in Fig. 1 was prepared.

As a substrate 1, a polyimide varnish was applied onto an alkali-free glass plate having a thickness of 0.7 mm, followed by baking to form a polyimide film with a thickness of 20 µm.

On the substrate 1, an aluminum alloy was deposited with a thickness of 100 nm using DC magnetron sputtering, and patterned into a desired shape using photolithography. Specifically, a photosensitive positive resist OFPR800 (Tokyo Ohka Kogyo Co., Ltd.) was applied, followed by mask exposure and alkaline development to form a resist pattern in a desired shape, and unnecessary portions of the aluminum alloy were etched away using an etchant mixture of phosphoric acid, nitric acid, and acetic acid. Then, the resist film was removed using a resist stripper to form a gate electrode 2 in a desired shape (such a patterning method is abbreviated as photolithography hereinafter).

Then, a photosensitive acrylic resin was applied using slit coating onto the substrate on which the gate electrode 2 was formed, followed by patterning using mask exposure and alkali development, and baking at 230°C to form a first gate insulating layer 3 in a desired shape. The baked first gate insulating layer 3 had a thickness of 1.0 µm. Also, the first gate insulating layer 3 had a relative dielectric constant of 3.6.

Then, chemical vapor deposition (CVD) was performed using silane (SiH₄) and nitrous oxide (N₂O) as material gas to form a second gate insulating layer 4 of silicon oxide on the substrate on which the first gate insulating layer 3 was formed. The second gate insulating layer 4 had a thickness of 30 nm. Also, the second gate insulating layer 4 had a relative dielectric constant of 5.0.

Then, an IGZO film was deposited with a thickness of 30 nm on the second gate insulating layer 4 by sputtering using a target material having a composition of InGaZnOx (IGZO), and argon (Ar) and oxygen (O₂) as sputtering gas, followed by patterning using photolithography to thereby form a semiconductor layer 5.

Furthermore, an acrylic resin was applied onto the semiconductor layer 5, followed by patterning using mask exposure and alkali development, and baking at 230°C to form a protective layer 6 in a desired shape. The protective layer 6 had a thickness of 0.6 µm.

Then, the second gate insulating layer 4 was patterned by reactive ion etching (RIE) using carbon tetrafluoride (CF₄) gas. In this case, as shown in Fig. 2(f), the portion of the second gate insulating layer 4 in an area overlapping the semiconductor layer 5 or the protective layer 6 is not etched because the semiconductor layer 5 or the protective layer 6 serves as a mask.

Then, molybdenum (Mo) was deposited with a thickness of 150 nm using sputtering, followed by patterning in a desired shape using photolithography to form a source electrode 7 and a drain electrode 8.

Through these processes, a thin-film transistor 100 according to the first embodiment of the present invention was prepared.

### (Example 2)

As Example 2, a thin-film transistor 101 shown in Fig. 5 was prepared.

As a substrate 1, a polyimide varnish was applied onto an alkali-free glass plate having a thickness of 0.7 mm, followed by baking to form a polyimide film with a thickness of 20 µm.

On the substrate 1, an aluminum alloy was deposited with a thickness of 100 nm using DC magnetron sputtering, and patterned into a desired shape using photolithography to form a gate electrode 2.

Then, a photosensitive acrylic resin was applied using slit coating onto the substrate on which the gate electrode 2 was formed, followed by patterning using mask exposure and alkali development, and baking at 230°C to form a first gate insulating layer 3 in a desired shape. The baked first gate insulating layer 3 had a thickness of 1.0 µm. Also, the first gate insulating layer 3 had a relative dielectric constant of 3.6.

Then, chemical vapor deposition (CVD) was performed using silane (SiH₄) and nitrous oxide (N₂O) as material gas to form a second gate insulating layer 4 made of silicon oxide (SiOₓ) on the substrate on which the first gate insulating layer 3 was formed. The second gate insulating layer 4 had a thickness of 30 nm. Also, the second gate insulating layer 4 had a relative dielectric constant of 5.0.

Then, an IGZO film was deposited with a thickness of 30 nm on the second gate insulating layer 4 by sputtering using a target material having a composition of InGaZnOx (IGZO), and argon (Ar) and oxygen (O₂) as sputtering gas, followed by patterning using photolithography to thereby form a semiconductor layer 5.

After depositing a first protective layer 6a of silicon oxide (SiOₓ) with a thickness of 30 nm on the semiconductor layer 5 using CVD, an acrylic resin was applied thereto, followed by patterning using mask exposure and alkali development, and baking at 230°C to obtain a second protective layer 6b in a desired shape. The protective layer 6b had a thickness of 0.7 µm.

Then, the first protective layer 6a and the second gate insulating layer 4 were patterned by reactive ion etching (RIE) using carbon tetrafluoride (CF₄) gas.

Then, molybdenum (Mo) was deposited with a thickness of 150 nm using sputtering, followed by patterning in a desired shape using photolithography to form a source electrode 7 and a drain electrode 8.

Through these processes, a thin-film transistor 101 according to the second embodiment of the present invention was prepared.

### (Example 3)

As Example 3, a thin-film transistor 100 shown in Fig. 1 was prepared.

As a substrate 1, a polyimide varnish was applied onto an alkali-free glass plate having a thickness of 0.7 mm, followed by baking to form a polyimide film with a thickness of 20 µm.

On the substrate 1, an aluminum alloy was deposited with a thickness of 100 nm using DC magnetron sputtering, and patterned into a desired shape using photolithography to form a gate electrode 2.

Then, a photosensitive acrylic resin was applied using slit coating onto the substrate on which the gate electrode 2 was formed, followed by patterning using mask exposure and alkali development, and baking at 230°C to form a first gate insulating layer 3 in a desired shape. The baked first gate insulating layer 3 had a thickness of 0.7 µm. Also, the first gate insulating layer 3 had a relative dielectric constant of 3.6.

Then, chemical vapor deposition (CVD) was performed using silane (SiH₄) and nitrous oxide (N₂O) as material gas to form a second gate insulating layer 4 made of silicon oxide (SiOₓ) on the substrate on which the first gate insulating layer 3 was formed. The second gate insulating layer 4 had a thickness of 10 nm. Also, the second gate insulating layer 4 had a relative dielectric constant of 5.0.

Then, an IGZO film was deposited with a thickness of 30 nm on the second gate insulating layer 4 by sputtering using a target material having a composition of InGaZnOx (IGZO), and argon (Ar) and oxygen (O₂) as sputtering gas, followed by patterning using photolithography to thereby form a semiconductor layer 5.

Furthermore, an acrylic resin was applied onto the semiconductor layer 5, followed by patterning using mask exposure and alkali development, and baking at 230°C to form a protective layer 6 in a desired shape. The protective layer 6 had a thickness of 0.6 µm.

Then, the second gate insulating layer 4 was patterned by reactive ion etching (RIE) using carbon tetrafluoride (CF₄) gas.

Then, molybdenum (Mo) was deposited with a thickness of 150 nm using sputtering, followed by patterning in a desired shape using photolithography to form a source electrode 7 and a drain electrode 8.

Through these processes, a thin-film transistor 100 according to the first embodiment of the present invention was prepared.

### (Comparative Example 1)

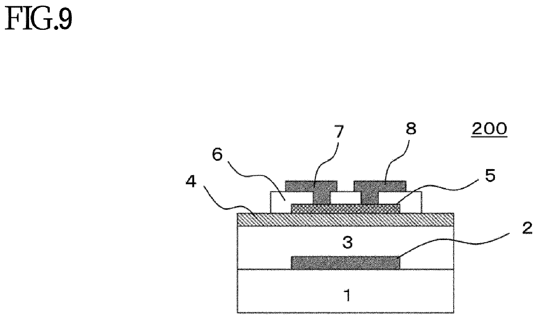

As Comparative Example 1, a thin-film transistor 200 shown in Fig. 9 was prepared.

As a substrate 1, a polyimide varnish was applied onto an alkali-free glass plate having a thickness of 0.7 mm, followed by baking to form a polyimide film with a thickness of 20 µm.

On the substrate 1, an aluminum alloy was deposited with a thickness of 100 nm using DC magnetron sputtering, and patterned into a desired shape using photolithography to form a gate electrode 2.

Then, a photosensitive acrylic resin was applied using slit coating onto the substrate on which the gate electrode 2 was formed, followed by patterning using mask exposure and alkali development, and baking at 230°C to form a first gate insulating layer 3 in a desired shape. The baked first gate insulating layer 3 had a thickness of 0.7 µm.

Then, chemical vapor deposition (CVD) was performed using silane (SiH₄) and nitrous oxide (N₂O) as material gas to form a second gate insulating layer 4 made of silicon oxide (SiOₓ) on the substrate on which the first gate insulating layer 3 was formed. The second gate insulating layer 4 had a thickness of 30 nm.

Then, an IGZO film was deposited with a thickness of 30 nm on the second gate insulating layer 4 by sputtering using a target material having a composition of InGaZnOx (IGZO), and argon (Ar) and oxygen (O₂) as sputtering gas, followed by patterning using photolithography to thereby form a semiconductor layer 5.

Next, an acrylic resin was applied onto the semiconductor layer 5, followed by patterning using mask exposure and alkali development, and baking at 230°C to form a protective layer 6 in a desired shape. The protective layer 6 had a thickness of 0.6 µm.

Then, molybdenum (Mo) was deposited with a thickness of 150 nm using sputtering, followed by patterning in a desired shape using photolithography to form a source electrode 7 and a drain electrode 8.

Through these processes, a thin-film transistor 200 according to Comparative Example 1 was prepared.

### (Comparative Example 2)

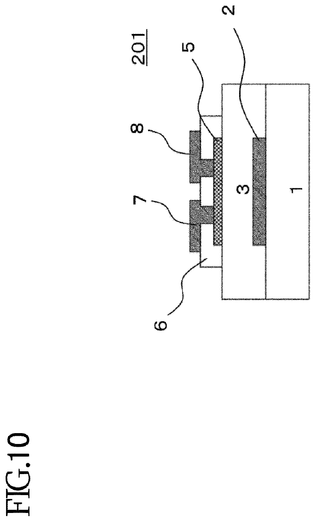

As Comparative Example 2, a thin-film transistor 201 shown in Fig. 10 was prepared.

As a substrate 1, a polyimide varnish was applied onto an alkali-free glass plate having a thickness of 0.7 mm, followed by baking to form a polyimide film with a thickness of 20 µm.

On the substrate 1, an aluminum alloy was deposited with a thickness of 100 nm using DC magnetron sputtering, and patterned into a desired shape using photolithography to form a gate electrode 2.

Then, a photosensitive acrylic resin was applied using slit coating onto the substrate on which the gate electrode 2 was formed, followed by patterning using mask exposure and alkali development, and baking at 230°C to form a first gate insulating layer 3 in a desired shape. The baked first gate insulating layer 3 had a thickness of 1.0 µm.

Then, an IGZO film was deposited with a thickness of 30 nm on the first gate insulating layer 3 by sputtering using a target material having a composition of InGaZnOx (IGZO), and argon (Ar) and oxygen (O₂) as sputtering gas, followed by patterning using photolithography to thereby form a semiconductor layer 5.

Furthermore, an acrylic resin was applied onto the semiconductor layer 5, followed by patterning using mask exposure and alkali development, and baking at 230°C to form a protective layer 6 in a desired shape. The protective layer 6 had a thickness of 0.6 µm.

Then, molybdenum (Mo) was deposited with a thickness of 150 nm using sputtering, followed by patterning in a desired shape using photolithography to form a source electrode 7 and a drain electrode 8.

Through these processes, a thin-film transistor 201 according to Comparative Example 2 was prepared.

The thin-film transistors of Examples 1 to 3 and Comparative Examples 1 and 2 prepared through the processes set forth above were compared with each other. In Examples 1 and 3, the gate insulating layer of the thin-film transistor is formed of two layers of the first and second gate insulating layers 3 and 4, with the area of the second gate insulating layer 4 being defined by the area of the semiconductor layer 5 or the protective layer 6, and with the second gate insulating layer 4 being formed in an island shape.

In Example 2, the gate insulating layer is formed as in Example 1, while the protective layer 6 is formed of the first and second protective layers 6a and 6b, with the first protective layer 6a and the second gate insulating layer 4 each being formed in an island shape.

Comparative Example 1 is different from Examples 1 and 3 in that the second gate insulating layer 4 is not patterned and the second gate insulating layer 4 has a sufficiently large area with respect to the channel region of the thin-film transistor 200.

Comparative Example 2 is different from Examples 1, 2 and 3 in that no second gate insulating layer 4 is formed.

To compare device characteristics between the thin-film transistors of Examples 1, 2 and 3 of the present invention and Comparative Examples 1 and 2, transmission characteristics of each of the thin-film transistor devices were measured. For measurements of transmission characteristics, a semiconductor parameter analyzer B 1500A (manufactured by Keysight Technologies) was used. Furthermore, to examine flexibility of the thin-film transistors prepared, each transistor was wrapped half a turn around a metal rod having a predetermined radius to measure transmission characteristics in the bent state.

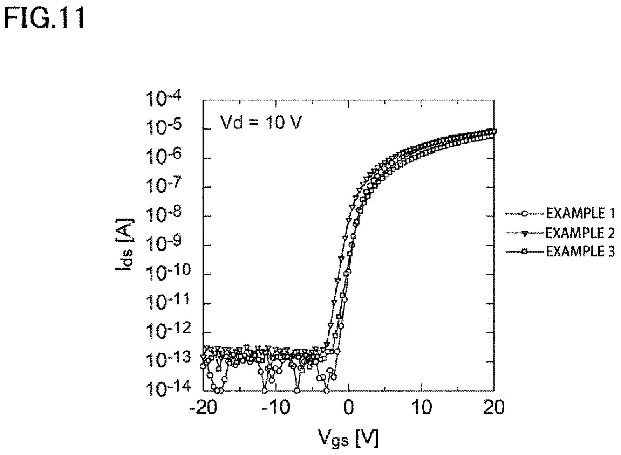

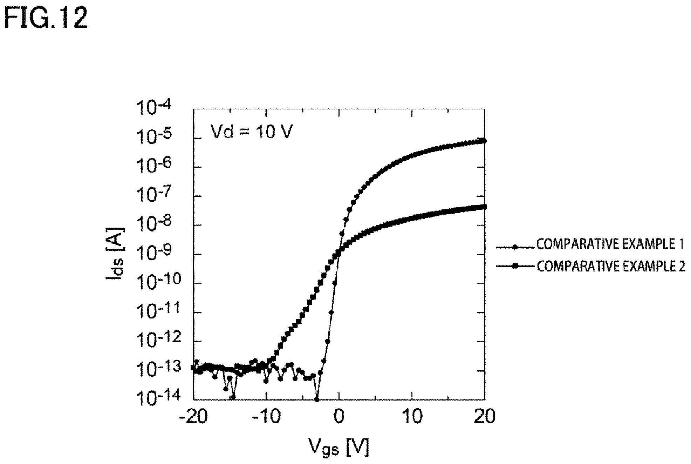

Figs. 11 and 12 show transmission characteristics of the thin-film transistors of Examples 1, 2 and 3 of the present invention and Comparative Examples 1 and 2 before being bent. Vgs represents voltage between the gate electrode and the source electrode, and Ids represents current between the drain electrode and the source electrode. Transmission characteristics were measured by setting the drain voltage to 10 V and the source voltage to 0 V, and sweeping the gate electrode from -20 V to 20 V. The measured thin-film transistors each had a channel size of 20 µm in length and 50 µm in width.

As can be seen from Figs. 11 and 12, Examples 1, 2 and 3 and Comparative Example 1 show good device characteristics, but in Comparative Example 2, sufficient transistor characteristics could not be obtained. This indicates that the second gate insulating layer 4 of each thin-film transistor of the present invention is extremely effective in obtaining good device characteristics.

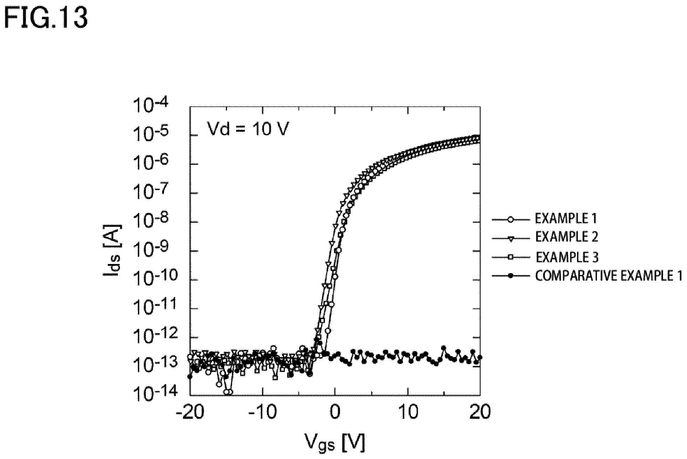

Fig. 13 shows transmission characteristics of the thin-film transistors of Examples 1, 2 and 3 and Comparative Example 1 measured after being bent at a radius of curvature R=1 mm. Examples 1, 2 and 3 show good device characteristics, but in the thin-film transistor 200 of Comparative Example 1, device characteristics could not be obtained. As a result of observing the thin-film transistor 200 of Comparative Example 1, the occurrence of cracking was confirmed in the second gate insulating layer 4 due to the bending. It is considered that this cracking had damaged the semiconductor layer, the source electrode, and the drain electrode, as a result of which no device characteristics could be detected.

Table 1 summarizes the results of the comparison in device characteristics and flexibility between Examples 1, 2 and 3 of the invention and Comparative Examples 1 and 2.

**[Table 1]**

| | No bending | R= 5 mm | R= 3 mm | R= 2 mm | R= 1 mm |
|---|---|---|---|---|---|
| Ex. 1 | Good | Good | Good | Good | Good |
| Ex. 2 | Good | Good | Good | Good | Good |
| Ex. 3 | Good | Good | Good | Good | Good |
| Comp. Ex. 1 | Good | Good | Good | Fair | Poor Cracking occurred |
| Comp. Ex. 2 | Poor | - | - | - | - |

As a result of experiments, the thin-film transistors 100 of Examples 1 and 3 and the thin-film transistor 101 of Example 2 showed good device characteristics even when bent at a small radius of curvature, indicating that thin-film transistors with extremely high flexibility could be produced.

### (Example 4)

As Example 4, a thin-film transistor 102 shown in Fig. 7(a) was prepared.

As a substrate 1, a polyimide varnish was applied onto an alkali-free glass plate having a thickness of 0.7 mm, followed by baking to form a polyimide film with a thickness of 20 µm.

On the substrate 1, an aluminum alloy was deposited with a thickness of 100 nm using DC magnetron sputtering, and patterned into a desired shape using photolithography. Specifically, a photosensitive positive resist OFPR800LB (Tokyo Ohka Kogyo Co., Ltd.) was applied, followed by mask exposure and alkaline development to form a resist pattern in a desired shape, and unnecessary portions of the aluminum alloy were etched away using an etchant mixture of phosphoric acid, nitric acid, and acetic acid. Then, the resist film was removed using a resist stripper to form a gate electrode 2 in a desired shape (such a patterning method is abbreviated as photolithography hereinafter).

Then, a photosensitive acrylic resin was applied using slit coating onto the substrate on which the gate electrode 2 was formed, followed by patterning using mask exposure and alkali development, and baking at 230°C to form a first gate insulating layer 3 in a desired shape. The baked first gate insulating layer 3 had a thickness of 1.0 µm. This insulating layer had a relative dielectric constant of 3.8.

Then, chemical vapor deposition (CVD) was performed using silane (SiH₄) and nitrous oxide (N₂O) as material gas to form a second gate insulating layer 4 of silicon oxide on the substrate on which the first gate insulating layer 3 was formed. The second gate insulating layer 4 had a thickness of 10 nm. Also, the second gate insulating layer 4 had a relative dielectric constant of 5.0.

Then, an IGZO film was deposited with a thickness of 30 nm on the second gate insulating layer 4 by sputtering using a target material having a composition of InGaZnOx (IGZO), and argon (Ar) and oxygen (O₂) as sputtering gas, followed by patterning using photolithography to thereby form a semiconductor layer 5.

The second gate insulating layer 4 was patterned using the resist used for patterning the semiconductor layer 5. The second gate insulating layer 4 was patterned by reactive ion etching (RIE) using carbon tetrafluoride (CF₄) gas.

Furthermore, a photosensitive acrylic resin solution, with a photosensitive nonionic fluorosurfactant added, was applied onto the semiconductor layer 5, followed by drying to remove the solvent, further followed by patterning using mask exposure and alkali development, and baking at 230°C to form a protective layer 6 in a desired shape. The protective layer 6 had a thickness of 0.6 µm. The concentration of the fluorosurfactant was 2.4% with respect to the solid content of the photosensitive acrylic resin solution. In order to measure surface energy and fluorine concentration of the protective layer 6, another protective layer 6 was prepared on a separate substrate for measurements. As a result of these measurements, the surface energy of the protective layer 6 was found to be 18.8 mJ/m². Surface energy was measured by measuring the contact angle between water and diiodomethane using a drop method, and calculating a value of surface energy from the measured contact angle based on the Kaelble-Uy method.

In order to detect the amount of fluorine in the depth direction of the protective layer 6, TOF-SIMS was used for analysis. Etching for the depth direction analysis was performed using an Ar gas cluster ion beam (GCIB). As a result, the fluorine content in the protective layer 6 was the highest at the surface, the concentration decreased from the surface to a depth of about 30 nm, and in deeper portions than this, the fluorine concentration was constant. The amount of fluorine on the topmost surface was approximately 170 times greater than in the portions where the fluorine concentration was constant.

Then, molybdenum (Mo) was deposited with a thickness of 150 nm using sputtering, followed by patterning in a desired shape using photolithography to form a source electrode 7 and a drain electrode 8.

Through these processes, a thin-film transistor 102 according to the third embodiment of the present invention was prepared.

### (Example 5)

As Example 5, a thin-film transistor 102 shown in Fig. 7(a) was prepared.

As a substrate 1, a polyimide varnish was applied onto an alkali-free glass plate having a thickness of 0.7 mm, followed by baking to form a polyimide film with a thickness of 20 µm.

On the substrate 1, an aluminum alloy was deposited with a thickness of 100 nm using DC magnetron sputtering, and patterned into a desired shape using photolithography to form a gate electrode 2.

Then, a photosensitive acrylic resin was applied using slit coating onto the substrate on which the gate electrode 2 was formed, followed by patterning using mask exposure and alkali development, and baking at 230°C to form a first gate insulating layer 3 in a desired shape. The baked first gate insulating layer 3 had a thickness of 1.0 µm. The first gate insulating layer 3 had a relative dielectric constant of 3.8.

Then, chemical vapor deposition (CVD) was performed using silane (SiH₄) and nitrous oxide (N₂O) as material gas to form a second gate insulating layer 4 of silicon oxide on the substrate on which the first gate insulating layer 3 was formed. The second gate insulating layer 4 had a thickness of 10 nm. Also, the second gate insulating layer 4 had a relative dielectric constant of 5.0.

Then, an IGZO film was deposited with a thickness of 30 nm on the second gate insulating layer 4 by sputtering using a target material having a composition of InGaZnOx (IGZO), and argon (Ar) and oxygen (O₂) as sputtering gas, followed by patterning using photolithography to thereby form a semiconductor layer 5.

The second gate insulating layer 4 was patterned using the resist used for patterning the semiconductor layer 5. The second gate insulating layer 4 was patterned by reactive ion etching (RIE) using carbon tetrafluoride (CF₄) gas.

Furthermore, a photosensitive acrylic resin solution, with a photosensitive nonionic fluorosurfactant added, was applied onto the semiconductor layer 5, followed by drying to remove the solvent, further followed by patterning using mask exposure and alkali development, and baking at 230°C to form a protective layer 6 in a desired shape. The protective layer 6 had a thickness of 0.6 µm. The concentration of the fluorosurfactant was 0.7% with respect to the solid content of the photosensitive acrylic resin solution. In order to measure surface energy and fluorine concentration of the protective layer 6, another protective layer 6 was prepared on a separate substrate for measurements. As a result of these measurements, the surface energy of the protective layer 6 was found to be 24.5 mJ/m². Surface energy was measured by measuring the contact angle between water and diiodomethane using a drop method, and calculating a value of surface energy from the measured contact angle based on the Kaelble-Uy method.

In order to detect the amount of fluorine in the depth direction of the protective layer 6, TOF-SIMS was used for analysis. Etching for the depth direction analysis was performed using an Ar gas cluster ion beam (GCIB). As a result, the fluorine content in the protective layer 6 was the highest at the surface, the concentration decreased from the surface to a depth of about 20 nm, and in deeper portions than this, the fluorine concentration was constant. The amount of fluorine on the topmost surface was approximately 200 times greater than in the portions where the fluorine concentration was constant.

Then, molybdenum (Mo) was deposited with a thickness of 150 nm using sputtering, followed by patterning in a desired shape using photolithography to form a source electrode 7 and a drain electrode 8.

Through these processes, a thin-film transistor 102 according to the third embodiment of the present invention was prepared.

### (Example 6)

As Example 6, a thin-film transistor containing no fluorine in the protective layer 6 was prepared.

As a substrate 1, a polyimide varnish was applied onto an alkali-free glass plate having a thickness of 0.7 mm, followed by baking to form a polyimide film with a thickness of 20 µm.

On the substrate 1, an aluminum alloy was deposited with a thickness of 100 nm using DC magnetron sputtering, and patterned into a desired shape using photolithography to form a gate electrode 2.

Then, a photosensitive acrylic resin was applied using slit coating onto the substrate on which the gate electrode 2 was formed, followed by patterning using mask exposure and alkali development, and baking at 230°C to form a first gate insulating layer 3 in a desired shape. The baked first gate insulating layer 3 had a thickness of 1.0 µm. This insulating layer had a relative dielectric constant of 3.8.

Then, chemical vapor deposition (CVD) was performed using silane (SiH₄) and nitrous oxide (N₂O) as material gas to form a second gate insulating layer 4 of silicon oxide on the substrate on which the first gate insulating layer 3 was formed. The second gate insulating layer 4 had a thickness of 10 nm. Also, the second gate insulating layer 4 had a relative dielectric constant of 5.0.

Then, an IGZO film was deposited with a thickness of 30 nm on the second gate insulating layer 4 by sputtering using a target material having a composition of InGaZnOx (IGZO), and argon (Ar) and oxygen (O₂) as sputtering gas, followed by patterning using photolithography to thereby form a semiconductor layer 5.

The second gate insulating layer 4 was patterned using the resist used for patterning the semiconductor layer 5. The second gate insulating layer 4 was patterned by reactive ion etching (RIE) using carbon tetrafluoride (CF₄) gas.

Furthermore, a photosensitive acrylic resin solution was applied onto the semiconductor layer 5, followed by drying to remove the solvent, further followed by patterning using mask exposure and alkali development, and baking at 230°C to form a protective layer 6 in a desired shape. The protective layer 6 had a thickness of 0.6 µm. In order to measure surface energy of the protective layer 6, another protective layer 6 was prepared on a separate substrate for measurements. As a result of these measurements, the surface energy of the protective layer 6 was found to be 45.0 mJ/m². Surface energy was measured by measuring the contact angle between water and diiodomethane using a drop method, and calculating a value of surface energy from the measured contact angle based on the Kaelble-Uy method.

Then, molybdenum (Mo) was deposited with a thickness of 150 nm using sputtering, followed by patterning in a desired shape using photolithography to form a source electrode 7 and a drain electrode 8.

Through these processes, a thin-film transistor containing no fluorine in the protective layer 6 was prepared. Example 6 does not correspond to the thin-film transistor 102 of the third embodiment of the invention because the protective layer 6 does not contain fluorine. However, Example 6 corresponds to the thin-film transistor according to the first embodiment of the invention in which the second gate insulating layer 4 is formed only in an area overlapping the semiconductor layer 5.

The thin-film transistors of Examples 4 to 6 prepared through the processes set forth above were compared with each other. Examples 4 and 5, in which the protective layer of the thin-film transistor is made of an organic material containing fluorine, are different from each other in the amount of fluorine contained in the protective layer. Example 6 is different from Examples 4 and 5 in that the protective layer contains no fluorine.

In order to compare device characteristics between the thin-film transistors of Examples 4, 5 and 6 of the present invention, transmission characteristics of these thin-film transistor devices were measured. For measurements of transmission characteristics, a semiconductor parameter analyzer B1500A (manufactured by Keysight Technologies) was used. Furthermore, in order to examine reliability of the thin-film transistors prepared, a negative bias stress (NBS) test was conducted. In order to examine flexibility of the thin-film transistors prepared, each transistor was wrapped half a turn around a metal rod having a predetermined radius to measure transmission characteristics in the bent state.

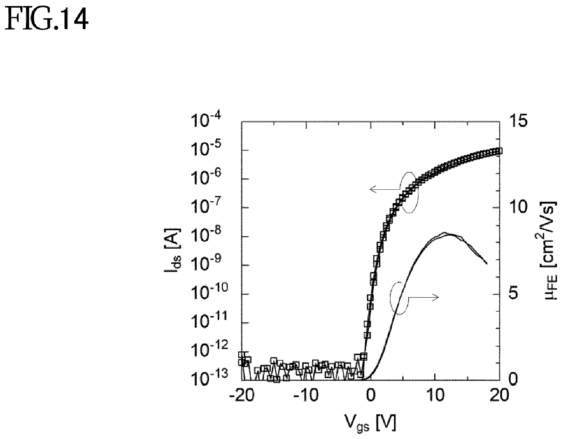

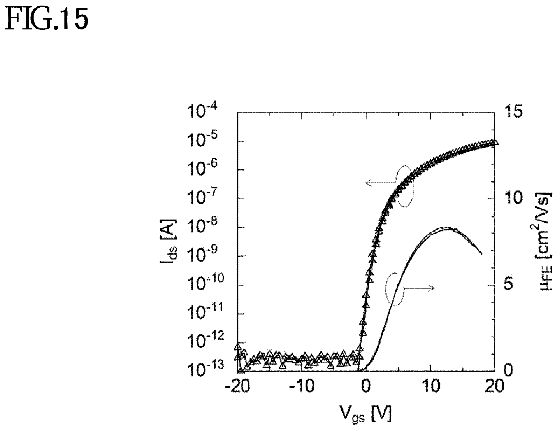

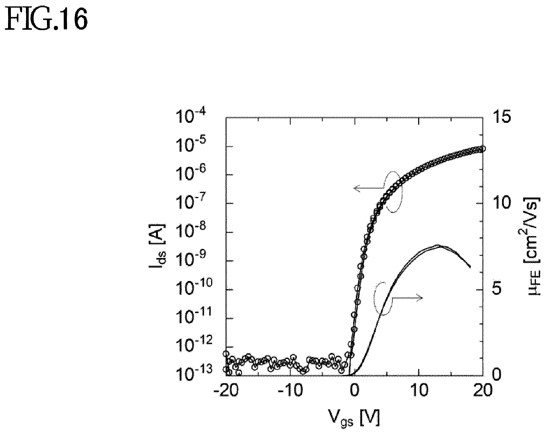

Figs. 14 to 16 are graphs respectively showing transmission characteristics of thin-film transistors of Examples 4, 5 and 6. Vgs represents voltage between the gate electrode and the source electrode, and Ids represents current between the drain electrode and the source electrode. Transmission characteristics were measured by setting the drain voltage to 10 V and the source voltage to 0 V, and sweeping the gate electrode from -20 V to 20 V. The measured thin-film transistors each had a channel size of 20 µm in length and 50 µm in width.

As can be seen in Figs. 14 to 16, Examples 4, 5, and 6 show good device characteristics. Table 2 shows values of device characteristics of the respective devices. Comparing values of the respective device characteristics, Examples 4 and 5, in which the protective layer 6 contains fluorine, have better device characteristics than Example 6, indicating the effect of the protective layer 6 due to containing fluorine.

**[Table 2]**

| | On-current [µA] | Mobility µ_{FE}[cm²/Vs] | Threshold ΔVth[V] | Hysteresis [V] | Threshold change ΔVth[V] |
|---|---|---|---|---|---|
| Ex. 4 | 9.4 | 8.4 | 2.7 | 0.18 | -0.12 |
| Ex. 5 | 9.2 | 8.2 | 2.8 | 0.19 | -0.20 |
| Ex. 6 | 8.3 | 7.5 | 3.0 | 0.26 | -1.10 |

The threshold change (ΔVth) in Table 2 shows change in threshold before and after the NBS test. The NBS test was conducting by setting the gate electrode voltage (Vgs) to -15 V, and the source voltage (Vs) and drain voltage (Vd) to 0 V, and applying a voltage for 1,000 seconds at a substrate temperature of 60°C. Examples 4 and 5 show smaller threshold changes than Example 6, from which it is understood that reliability of the thin-film transistor devices has been improved. This is because external influences have been effectively mitigated due to the protective layer 6 containing fluorine.
Furthermore, as a result of conducting a bending test for the thin-film transistors of Examples 4, 5 and 6, all of these thin-film transistors showed good device characteristics at a radius of curvature R=5 mm to R=1 mm without causing breakage (Table 3). This indicates that the thin-film transistors have high flexibility due to using an organic insulating material as the protective layers 6 of the thin-film transistors, regardless of the amount of fluorine in the protective layers 6.

**[Table 3]**

| | No bending | R= 5 mm | R= 3 mm | R= 2 mm | R= 1 mm |
|---|---|---|---|---|---|
| Ex. 4 | Good | Good | Good | Good | Good |
| Ex. 5 | Good | Good | Good | Good | Good |
| Ex. 6 | Good | Good | Good | Good | Good |

As a result of experiments, the thin-film transistors 102 of Examples 4 and 5 of the present invention had good device characteristics even when bent at a small radius of curvature, indicating that thin-film transistors having good device characteristics with extremely high flexibility and high reliability could be produced.

According to the present invention, there can be provided a thin-film transistor having good device characteristics and high flexibility, a thin-film transistor array, and a method of producing a thin-film transistor.

Some embodiments of the present invention have been described so far, but the present invention should not be construed as being limited to these embodiments but can be modified in various ways within the range not departing from the spirit of the present invention.

### [Reference Signs List]

- 1: Substrate
- 2: Gate electrode
- 3: First gate insulating layer
- 4: Second gate insulating layer
- 5: Semiconductor layer
- 6: Protective layer
- 7: Source electrode
- 8: Drain electrode
- 100, 101, 102, 103: Thin-film transistor

## Claims

1. A thin-film transistor comprising an insulating substrate, a gate electrode, a first gate insulating layer, a second gate insulating layer, a semiconductor layer, an insulating protective layer, a source electrode, and a drain electrode, wherein
the first gate insulating layer is made of an insulating material containing an organic material;
the second gate insulating layer is made of an inorganic insulating material;
the second gate insulating layer has a thickness that is smaller than that of the first gate insulating layer; and
the second gate insulating layer is formed only in an area overlapping the semiconductor layer or the protective layer.

2. The thin-film transistor according to claim 1, wherein
the semiconductor layer is made of an oxide of a metal selected from indium, gallium, zinc and tin, or made of silicon.

3. The thin-film transistor according to claim 1 or 2, wherein
the second gate insulating layer has a thickness of 2 nm or more and 100 nm or less.

4. The thin-film transistor according to any one of claims 1 to 3, wherein
the second gate insulating layer is made of silicon oxide or an oxide of a metal selected from aluminum, tantalum, hafnium, yttrium and zirconium.

5. The thin-film transistor according to any one of claims 1 to 3, wherein
the second gate insulating layer is made of silicon nitride.

6. The thin-film transistor according to any one of claims 1 to 5, wherein
the first gate insulating layer is made of an organic polymer material.

7. The thin-film transistor according to any one of claims 1 to 6, wherein
the protective layer is made of an organic material containing fluorine.

8. The thin-film transistor according to any one of claims 1 to 7, wherein
the protective layer is formed of a first protective layer and a second protective layer.

9. A thin-film transistor array in which the thin-film transistors according to any one of claims 1 to 8 are arrayed, wherein
the second gate insulating layers and the protective layers are formed in respective regions in each of which wiring of the gate electrodes intersects wiring of the source electrodes.

10. A method of producing the thin-film transistor according to any one of claims 1 to 7, wherein
patterning of the semiconductor layer and the protective layer is followed by patterning of the second gate insulating layer.

11. The method of producing the thin-film transistor according to claim 10, wherein
the second gate insulating layer is etched using the semiconductor layer or the protective layer as a mask.

12. The method of producing the thin-film transistor according to any one of claims 1 to 7, wherein
patterning of the semiconductor layer is followed by patterning of the second gate insulating layer.

13. The method of producing the thin-film transistor according to claim 12, wherein
the second gate insulating layer is etched using a resist used for patterning the semiconductor layer as a mask.

14. A method of producing the thin-film transistor according to claim 8, wherein
patterning of the semiconductor layer and the second protective layer is followed by patterning of the first protective layer and the second gate insulating layer.

15. The method of producing the thin-film transistor according to claim 14, wherein
the first protective layer and the second gate insulating layer are etched using the semiconductor layer or the second protective layer as a mask.
